# EUROPÄISCHE PATENTSCHRIFT

(11) **EP 1 134 659 B1**
(45) Veröffentlichungstag und Bekanntmachung des Hinweises auf die Patenterteilung: **19.10.2005**
(21) Anmeldenummer: 01104907.9
(22) Anmeldetag: 28.02.2001
(51) Int. Cl.: G06F 11/20

(54) **Redundanz-Multiplexer für Halbleiterspeicheranordnung**
Redundancy multiplexer for semiconductor memory device
Multiplexeur de redondance pour mémoire à semi-conducteur

(30) Priorität: 13.03.2000 DE 10012104
(43) Veröffentlichungstag der Anmeldung: 19.09.2001
(73) Patentinhaber: Infineon Technologies AG, 81669 München (DE)
(72) Erfinder: Nygren, Aaron, 81667 München (DE)
(74) Vertreter: Müller - Hoffmann & Partner

(56) Entgegenhaltungen:
- EP-A- 0 401 957
- XP000216720

## Beschreibung

Die vorliegende Erfindung betrifft einen Redundanz-Multiplexer für eine Halbleiterspeicheranordnung zum Ersetzen von zwei fehlerhaften Bitleitungen durch zwei redundante Bitleitungen, bei dem aus in Fuses abgespeicherter Information, welche Bitleitungen zu ersetzen sind, in einem Decoder Steuer- bzw. Schaltsignale erzeugt werden, und bei dem zwei Redundanzbereiche mit den redundanten Bitleitungen beidseitig zu einem Zentralbus von dem Steuer- bzw. Schaltsignal auswählbar sind.

Ein Redundanz-Multiplexer nach dem Oberbegriff des Patentanspruches ist aus der Patentschrift EP-A-0 401 957 bekannt.

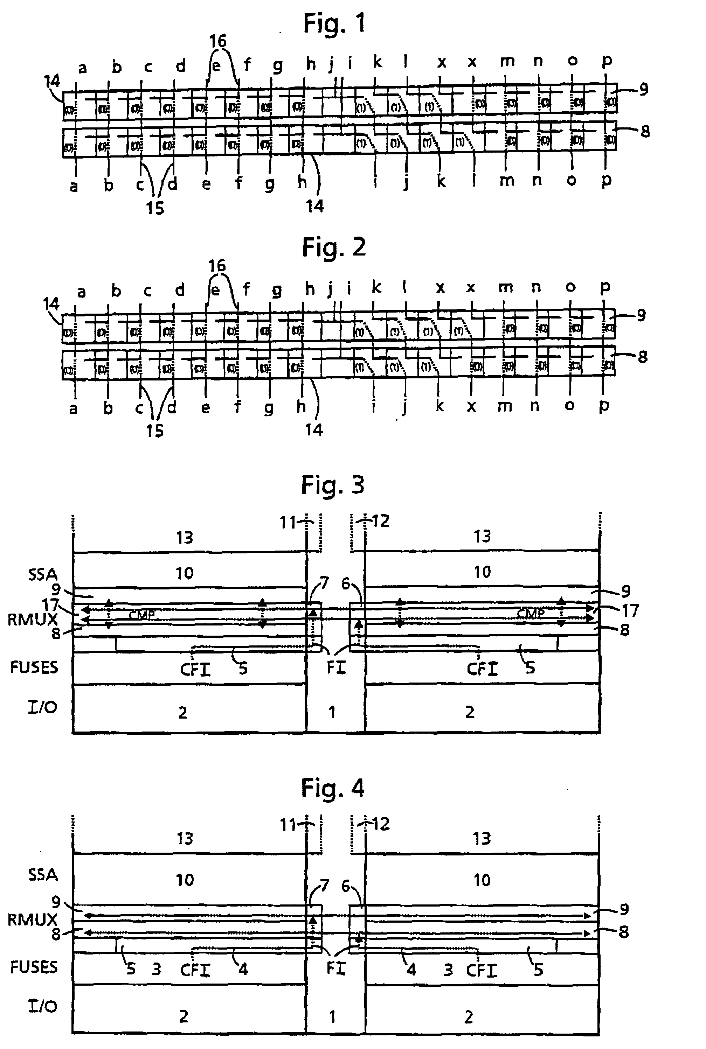

Fig. 4 zeigt den Aufbau eines herkömmlichen Redundanz-Multiplexers für eine Halbleiterspeicheranordnung. Beidseitig von einem Zentralbus bzw. Zentralbereich 1 ist eine Eingabe/Ausgabeeinheit (I/O) 2 vorgesehen, in die Information eingegeben wird, welche Bitleitungen fehlerhaft sind und durch redundante Bitleitungen ersetzt werden müssen. Dabei können selbstverständlich soviele Bitleitungen durch redundante Bitleitungen ersetzt werden, wie redundante Bitleitungen insgesamt vorhanden sind. Diese Information über fehlerhafte Bitleitungen wird in Fuses (FUSES) 3 abgelegt, so daß hier codierte Fuse-Information CFI vorliegt, die angibt, welche Bitleitungen fehlerhaft sind und durch redundante Bitleitungen ersetzt werden müssen. Es sei nun angenommen, daß diese codierte Fuse-Information CFI auf jeder Seite des Zentralbusses 1 über einen entsprechenden, schematisch durch eine Punktlinie angedeuteten Fuse-Bus 4 über einen Puffer und Decoder 5, der decodierte Fuse-Information FI liefert, direkt oder über beim Lesen oder Schreiben verwendete Steuereinheiten 6, 7 zu einem Redundanz-Multiplexer (RMUX) 8, 9 abgegeben wird.

Beispielsweise wird also von den in Fig. 4 rechts von dem Zentralbus 1 gelegenen Fuses 3 die codierte Fuse-Information CFI über den Puffer und Decodierer 5, der daraus die decodierte Fuse-Information FI erzeugt, zu der Steuereinheit 6 gesandt und von dieser über der gesamten Schnittstellenbreite des Redundanz-Multiplexers 9 verteilt, bevor die zugehörige redundante Bitleitung in einem Bereich 11 neben einem Leseverstärker (SSA) folgenden Speicherzellenfeld 13 angesteuert wird.

Bei der Prüfung von Halbleiterspeicheranordnungen liegt es im allgemeinen in der Entscheidung der Testperson, die einer vorliegenden fehlerhaften Bitleitung zugeordneten Fuses zu brennen bzw. auszuwählen, um so die fehlerhafte Bitleitung durch eine redundante Bitleitung zu ersetzen.

Allerdings tritt ein ernsthaftes Problem auf, wenn beim Zuweisen einer redundanten Bitleitung zu einer zweiten fehlerhaften Bitleitung die Position der bereits durch eine erste redundante Bitleitung ersetzten ersten fehlerhaften Bitleitung berücksichtigt werden muß. Dies ist für Redundanz-Multiplexer von eDRAMs der neueren Generation der Fall.

Es ist daher Aufgabe der vorliegenden Erfindung, einen Redundanz-Multiplexer für insbesondere eDRAMs zu schaffen, bei dem die Lage einer ersten fehlerhaften Bitleitung, die durch eine redundante Bitleitung ersetzt ist, bei der Zuordnung einer zweiten redundanten Bitleitung, die eine zweite fehlerhafte Bitleitung ersetzen soll, berücksichtigt wird.

Diese Aufgabe wird bei einem Redundanz-Multiplexer der eingangs genannten Art erfindungsgemäß dadurch gelöst, daß durch Vergleich der beiden Steuer- bzw. Schaltsignale zu jeweils zwei hintereinanderliegenden Schaltern des Multiplexers festgestellt wird, ob die Schalter entsprechend der Anzahl der fehlerhaften Bitleitungen richtig gestellt sind.

Bei dem erfindungsgemäßen Redundanz-Multiplexer liegen also jeweils Vergleicher zwischen zwei in Reihe zueinander vorgesehenen Schaltern. Diese Vergleicher vergleichen mit dem Steuer- bzw. Schaltsignal die zu jedem Schalter gesandte decodierte Adresse ("1" oder "0") und vertauschen gegebenenfalls diese Adressen, falls dies erforderlich ist, damit die fehlerhafte Adresse, die näher bei den zentralen Redundanz-Bereichen ist, die Schalter steuert, die näher zu dem Speicherzellenfeld sind. Nur wenn diese Bedingung erfüllt ist, werden keine Daten aus fehlerhaften Bitleitungen gelesen. Ein solches fehlerhaftes Lesen kann also durch Vertauschen der Adressen mittels der Vergleicher zwischen den Schaltern ausgeschlossen werden. Sollte bei einer Halbleiterspeicheranordnung mit dem erfindungsgemäßen Redundanz-Multiplexer ein Fehler in einer ersten Bitleitung auftreten, so kann mit der vorliegenden Erfindung ein erster Satz von Fuses gebrannt werden, um diesen Fehler zu korrigieren, indem die fehlerhafte Bitleitung durch eine redundante Bitleitung ersetzt wird. Wird anschließend ein zweiter Fehler in einer anderen Bitleitung festgestellt, so daß eine zweite fehlerhafte Bitleitung vorliegt, kann ein zweiter Satz von Fuses gebrannt werden, was unabhängig von dem zuerst ermittelten Fehler geschieht. Dies bedeutet, daß der zuerst ermittelte Fehler nach dem Brennen des ersten Satzes von Fuses nicht in einem Tester abgesoeichert zu werden braucht. Hierdurch kann ohne weiteres der Speicher im Tester eingespart werden.

Bei herkömmlichen Anordnungen ist ein Abspeichern der Fehler im Tester notwendig, da die Reihenfolge der Ersetzungen ermittelt werden muß, bevor Fuses gebrannt werden können. Bei der vorliegenden Erfindung wird diese Reihenfolge direkt ermittelt, so daß sofort eine Fuse gebrannt werden kann, wenn ein Fehler auftritt.

Nachfolgend wird die Erfindung anhand der Zeichnungen näher erläutert. Es zeigen:
- Fig. 1: ein Ausführungsbeispiel des erfindungsgemäßen Redundanz-Multiplexers mit richtiger Zuordnung der Adressen,
- Fig. 2: den Multiplexer von Fig. 1 mit unrichtiger Zuordnung der Adressen,
- Fig. 3: eine schematische Darstellung des erfindungsgemäßen Redundanz-Multiplexers für eine Halbleiterspeicheranordnung und
- Fig. 4: eine schematische Darstellung eines bestehenden Redundanz-Multiplexers für eine Halbleiterspeicheranordnung.

Die Fig. 4 ist bereits eingangs erläutert worden. In den Figuren werden für einander entsprechende Bauteile jeweils die gleichen Bezugszeichen verwendet.

Ein Redundanz-Multiplexer 8 bzw. 9 besteht, wie aus den Fig. 1 und 2 zu ersehen ist, aus einer Vielzahl von Schaltern 14, die Stellungen (0) und (1) haben können. In Eingänge 15 dieser Schalter 14 werden Daten eingespeist, die zu Bitleitungen, die an Ausgänge 16 des Multiplexers 9 angeschlossen sind, weitergeleitet werden sollen. Werden nun fehlerhafte Bitleitungen "X" festgestellt, so werden durch die von einem Decoder 5 (vgl. Fig. 3 und 4) gelieferten Steuer- bzw. Schaltsignale die Schalter 14 so angesteuert, daß in Fig. 1 die von den fehlerhaften Bitleitungen "X" links gelegenen Bitleitungen deren Funktion übernehmen, wobei diese Funktionsübernahme bis zu den redundanten Bitleitungen im Bereich des Zentralbusses 1 weitergeschoben wird. Hierzu nehmen die entsprechenden Schalter 14 die Stellung (1) ein.

Aus Fig. 1 ist ohne weiteres zu erkennen, in welcher Weise die einzelnen Anschlüsse "a" ... "p" der Multiplexer 8 und 9 einander zugeordnet sind und wie die Anschlüsse "j" und "i" in den Redundanz-Bereichen 11 bzw. 12 zu redundanten Bitleitungen geführt sind, welche die fehlerhafte Bitleitungen "X" ersetzen.

Fig. 2 zeigt die gleiche Anordnung wie Fig. 1 mit der Ausnahme, daß die Schalter in der rechten Hälfte mit den Anschlüssen "i" bis "p" des Redundanz-Multiplexers 9 bzw. des Multiplexers 8 Stellungen (1,1,1,1,0,0,0,0; 1,1,1,0,0,0,0,0) anstelle von (1,1,1,0,0,0,0,0; 1,1,1,1,0,0,0,0) haben. Mit anderen Worten, bei den mit dem Anschluß "1" des Multiplexers 8 verbundenen Schaltern 14 liegen in Fig. 2 die Steuer- bzw. Schaltsignale oder auch "Adressen" (0) und (1) für die Multiplexer 8 und 9 an, während in Fig. 1 diese Schalt- bzw. Steuersignale die Werte (1) und (0) haben. Infolge dieser Vertauschung der Adressen bei diesem Schalter 14 tritt beim Lesen des Speicherzellenfeldes eine fehlerhafte Bitleitung "X" des Multiplexers 8 in Erscheinung.

Dieses unerwünschte Ergebnis kann erfindungsgemäß dadurch verhindert werden, daß die einzelnen Steuer- bzw. Schaltsignale oder Adressen (1) und (0) miteinander verglichen und gegebenenfalls vertauscht werden, wenn das Steuer- bzw. Schaltsignal mit einer Adresse für eine redundante Bitleitung nur denjenigen Schalter (14) von den beiden hintereinander liegenden Schaltern (14) steuert, der näher bei dem Speicherzellenfeld (13) angeordnet ist.

Dieses Vertauschen wird in einfacher Weise durch Vergleicher 17 vorgenommen, welche einen Vergleich "CMP" der Steuer- bzw. Schaltsignale der Multiplexer 8, 9 vornehmen und gegebenenfalls einen Adressenaustausch bewirken (Fig. 3).

Die Erfindung stellt so in zuverlässiger Weise sicher, daß beim Auslesen des Speicherzellenfeldes 13 keine fehlerhaften Bitleitungen "X" in Erscheinung treten.

## Patentansprüche

1. Redundanz-Multiplexer für Halbleiterspeicheranordnung mit einem Speicherzellenfeld (13) zum Ersetzen von zwei fehlerhaften Bitleitungen (X) durch zwei redundante Bitleitungen, bei dem aus in Fuses (3) abgespeicherter Information, welche Bitleitungen zu ersetzen sind, in einem Decoder (5) Steuer- bzw. Schaltsignale ("0" bzw. "1") für jeweils zwei hintereinander liegende Schalter (14) des Multiplexers (8, 9) erzeugt werden, und bei dem zwei redundante Bitleitungen in zwei Redundanz-Bereichen (11, 12) beidseitig zu einem Zentralbus (1) von Adressen des Steuer- bzw. Schaltsignals auswählbar sind,
**dadurch gekennzeichnet, dass**
zwischen jeweils zwei hintereinander liegenden Schaltern (14) des Redundanz-Multiplexers ein Vergleicher (17) vorgesehen ist, der die beiden eine Adresse einer redundanten Bitleitung aufweisenden Steuer- bzw. Schaltsignale zu den jeweils zwei hintereinander liegenden Schaltern (14) miteinander vergleicht und gegebenenfalls vertauscht, wenn das Steuer- bzw. Schaltsignal mit einer Adresse für eine redundante Bitleitung nur denjenigen Schalter (14) von den beiden hintereinander liegenden Schaltern (14) steuert, der näher bei dem Speicherzellenfeld (13) angeordnet ist.

## Claims

1. Redundant multiplexer for a semiconductor memory arrangement having a memory cell array (13) for replacement of two faulty bit lines (X) by two redundant bit lines, in which control and switching signals ("0" and "1", respectively) for in each case two series-connected switches (14) in the multiplexer (8, 9) are produced in a decoder (5) from information which is stored in fuses (3) about which bit lines must be replaced, and in which two redundant bit lines in two redundant areas (11, 12) on both sides of a central bus (1) can be selected by addresses of the control and switching signal,
**characterized in that**
a comparator (17) is provided between in each case two series-connected switches (14) and compares the two control and switching signals, which have an address of a redundant bit line, to the in each case two series-connected switches (14) with one another and, if necessary, interchanges them, if the control and switching signal with an address for a redundant bit line controls only that switch (14) of the two series-connected switches (14) which is arranged relatively close in the memory cell array (13).

## Revendications

1. Multiplexeur de redondance pour des dispositifs de mémoire à semi-conducteurs ayant un champ (13) de cellules de mémoire pour le remplacement de deux lignes (X) de bits défectueuses par deux lignes de bits redondantes, dans lequel, à partir des informations mémorisées dans des fusibles (3) indiquant les lignes de bits à remplacer, il est produit dans un décodeur (5) des signaux de commande ou de commutation (« 0 » ou « 1 ») pour, respectivement, deux commutateurs (14) se succédant du multiplexeur, et dans lequel on peut choisir deux lignes de bits redondantes dans deux zones (11, 12) de redondance de part et d'autre d'un bus (1) central d'adresse du signal de commande ou de commutation,
**caractérisé en ce que**, entre, respectivement, deux commutateurs (14) se succédant du multiplexeur de redondance, il est prévu un comparateur (17) qui compare entre eux les deux signaux de commande ou de commutation comportant une adresse d'une ligne de bits redondante aux deux commutateurs (14) respectifs qui se succèdent et, le cas échéant, les intervertit si le signal de commande ou de commutation ayant une adresse pour une ligne de bits redondante ne commande que le commutateur (14) parmi les deux commutateurs (14) qui se succèdent qui est le plus proche du champ (13) de cellules de mémoire.
